(19) Europäisches Patentamt
European Patent Office
Office européen des brevets

(11) **EP 3 015 522 A1**

(12) **EUROPEAN PATENT APPLICATION**
published in accordance with Art. 153(4) EPC

(43) Date of publication:
**04.05.2016 Bulletin 2016/18**

(21) Application number: **14816662.2**

(22) Date of filing: **27.06.2014**

(51) Int Cl.:
**C09J 131/04** (2006.01)   **B32B 7/12** (2006.01)
**C03C 27/12** (2006.01)   **C09J 5/06** (2006.01)
**C09J 7/00** (2006.01)   **C09J 11/06** (2006.01)
**C09J 123/08** (2006.01)

(86) International application number:
**PCT/JP2014/067281**

(87) International publication number:
**WO 2014/208756 (31.12.2014 Gazette 2014/53)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **28.06.2013 JP 2013135921**

(71) Applicant: **Bridgestone Corporation Tokyo 104-8340 (JP)**

(72) Inventors:
• **OMURA Kazuhiro**
  **Yokohama-shi**
  **Kanagawa 244-8510 (JP)**

• **WATANABE Masakuni**
  **Yokohama-shi**
  **Tokyo 244-8510 (JP)**
• **HASHIMOTO Masao**
  **Yokohama-shi**
  **Kanagawa 244-8510 (JP)**
• **SUZUKI Yuji**
  **Yokohama-shi**
  **Kanagawa 244-8510 (JP)**
• **FUNAKI Tatsuya**
  **Yokohama-shi**
  **Kanagawa 244-8510 (JP)**

(74) Representative: **Oxley, Robin John George Marks & Clerk LLP 90 Long Acre London WC2E 9RA (GB)**

(54) **SHEET FOR FORMING LAMINATE, AND METHOD FOR PRODUCING LAMINATE**

(57)    The present invention provides a sheet for forming a laminate, mainly composed of EVA, wherein the sheet allows a sufficient removal of air bubbles in a laminate to be performed by a step of pressurizing the laminate by using nip rolls, and allows a satisfactory laminate to be produced, and provides a method for producing the laminate.

In other words, the present invention provides a sheet for forming a laminate used in a method for producing a laminate including a step of application of pressure by using nip rolls, wherein the sheet for forming a laminate is formed of a composition including an ethylene-vinyl acetate copolymer and a cross-linking agent, the content of vinyl acetate in the ethylene-vinyl acetate copolymer is 30% by mass or more in relation to the ethylene-vinyl acetate copolymer, and the melt flow rate according to JIS-K7210 of the ethylene-vinyl acetate copolymer is 5 g/10 min or less, and the method for producing a laminate, using the sheet for forming a laminate.

Fig. 1

**Description**

Technical Field

The present invention relates to a sheet for forming a laminate, for example, such as a sealing film for a solar cell and an intermediate film for a laminated glass, which is mainly composed of ethylene-vinyl acetate copolymer, to be used for production of a laminate such as a laminated glass and a solar cell module, in particular, a sheet for forming a laminate useful for production of a laminate including a step of application of pressure with nip rolls.

Background Art

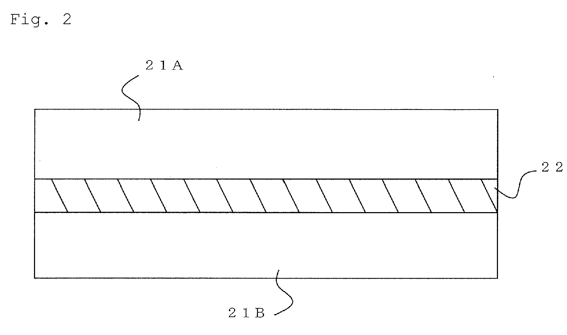

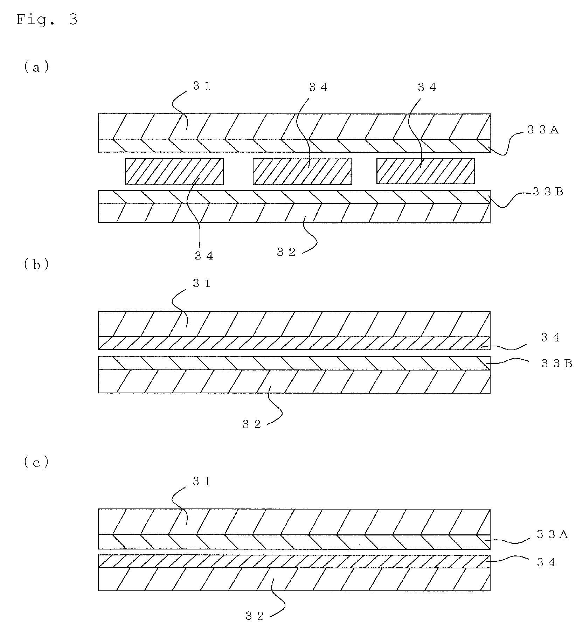

A sheet mainly composed of ethylene-vinyl acetate copolymer (hereinafter, also referred to as EVA, and the sheet mainly composed of EVA is also referred to as the EVA sheet) has hitherto been used as a sheet for forming a laminate such as an intermediate film for a laminated glass or a sealing film for a solar cell because the sheet mainly composed of ethylene-vinyl acetate copolymer is inexpensive and has excellent adhesiveness and high transparency. As shown in Fig. 2, an intermediate film for a laminated glass is held between glass plates 21A and 21B, and exhibits a function such as penetration resistance or prevention of scattering of broken glass pieces. As shown in (a) to (c) of Fig. 3, a sealing film for a solar cell is disposed between a solar cell element 34 and a front-side transparent protective member 31 formed of a glass substrate or the like, and/or between a solar cell element 34 and a back-side protective member (back cover) 32, and exhibits a function such as securing of electric insulation or securing of mechanical durability. The EVA sheet can be improved in the properties thereof such as adhesiveness, penetration resistance, and durability by cross-linking the copolymer with a cross-linking agent such as an organic peroxide.
In the production of a laminate such as a laminated glass, when materials for a laminate such as a plurality of sheets of glass plates and a sheet for forming a laminate are combined and processed, the air present in the boundary surfaces between the sheet for forming a laminate and the glass plates or the like is required to be discharged so as for air bubbles not to occur. This is because when air bubbles are present in a laminate such as a laminated glass, the performance degradation due to the degradation of transparency or the exterior appearance failure sometimes occurs.
Thus, as a method for producing a laminate such as a laminated glass, for example, the following methods are used: (1) a method in which a sheet for forming a laminate is held between a plurality of substrates, the resulting laminate is placed in a vacuum bag and deaerated, and pressurized under heating for a preliminary pressure bonding, thus the air present in the sheet for forming a laminate and in the boundaries between the sheet for forming a laminate and the substrates is removed to such a degree that air bubbles remain slightly, and subsequently, the air bubbles are sufficiently removed, by performing final heating and pressurization by using a high temperature-high pressure vessel; (2) a method in which a sheet for forming a laminate is held between a plurality of substrates, the resulting laminate is heated while the laminate is being conveyed so as to pass through a heating zone, then the laminate is held between nip rolls to be pressurized for a preliminary pressure bonding, thus the air in the boundaries between the substrates and the sheet for forming a laminate is squeezed out to be removed, and then, if necessary, the final heating and pressurization by using a high temperature-high pressure vessel are performed.
In general, the method of (2) using nip rolls is advantageous in that the step of bonding by application of pressure can be performed continuously. For example, Patent Literature 1 discloses a method for continuously producing a laminated glass by contact pressure exerted by nip rolls, by using an intermediate film made of a resin having specific viscoelastic properties (glass transition temperature, storage modulus of elasticity) and having a thickness falling within a predetermined range, in order to streamline the production process of the laminated glass. Patent Literature 2 also discloses a method in which the air in the laminate is removed by using pressure bonding rolls (nip rolls) as an inexpensive method for producing an amorphous solar cell module. Usually, the method of (2) using nip rolls is suitably used when there is used a sheet mainly composed of polyvinyl butyral (hereinafter, also referred to as PVB) generally used as a sheet for forming a laminate such as an intermediate film for a laminated glass.
However, when an EVA sheet is used as the sheet for forming a laminate, there is, for example, a restriction such that the increase of the thickness makes air bubbles be hardly removed, and hence the method of (1) using the step of preliminary pressure bonding employing a vacuum bag is currently predominantly used. Accordingly, there has been investigated a method for efficiently producing a laminate by using the method of (2) employing nip rolls even when an EVA sheet is used; recently, it has been found that by using an intermediate film for a laminated glass formed of an EVA sheet having a specific melt viscosity, specific surface properties and a specific thickness, a pressure bonding step using nip rolls enables satisfactory removal of air bubbles in the laminated glass (Patent Literature 3).

Citation List

Patent Literature

Patent Literature 1: JP A 11-209150
Patent Literature 2: JP A 07-169986
Patent Literature 3: JP A 2012-66984

Summary of Invention

Technical Problem

However, the production method of Patent Literature 3 has restrictions on the conditions of the predetermined melt viscosity, surface properties and thickness of an EVA sheet, and hence a further less restrictive method is desired.
Accordingly, an object of the present invention is to provide a sheet for forming a laminate, mainly composed of EVA, wherein the sheet allows a sufficient removal of air bubbles in a laminate to be performed by a step of application of pressure by using nip rolls, and allows a satisfactory laminate to be produced.
Another object of the present invention is to provide a method for producing a laminate, using the sheet for forming a laminate, mainly composed of EVA, wherein the method allows a sufficient removal of air bubbles in a laminate to be performed by a step of pressurizing the laminate by using nip rolls, and allows a satisfactory laminate to be produced.

Solution to Problem

According to the investigation of the present inventors, it has been revealed that in the heating apparatus used before the application of pressure with nip rolls, the laminate is hardly uniformly heated, in such a way that temperature distribution sometimes occurs in the plan view center and the plan view periphery of the laminate. EVA has a tendency for the viscosity thereof to drastically decrease when the temperature reaches a certain temperature, and accordingly when the temperature distribution occurs in the EVA sheet in the laminate, there sometimes occurs a large difference between the viscosities (fluidities) of the EVA in the plan view center and the plan view periphery of the EVA sheet. This difference of the viscosity (fluidity) was regarded as one of the factors that made the air bubbles in the boundary between the EVA sheet and the substrate be hardly removed during the pressurization with nip rolls. Accordingly, the present inventors further investigated the constitution of EVA in which the viscosity variation (fluidity variation) in relation to the temperature variation was suppressed, and have reached the present invention.
In other words, the above-described object is achieved by a sheet for forming a laminate used in a method for producing a laminate comprising a step of application of pressure by using nip rolls, wherein the sheet for forming a laminate is formed of a composition comprising an ethylene-vinyl acetate copolymer and a cross-linking agent, the content of vinyl acetate in the ethylene-vinyl acetate copolymer is 30% by mass or more in relation to the ethylene-vinyl acetate copolymer, and the melt flow rate according to JIS-K7210 of the ethylene-vinyl acetate copolymer is 5 g/10 min or less.
The EVA having such a content of vinyl acetate and a melt flow rate (hereinafter, also referred to as MFR) as described above can be an EVA suppressed in the viscosity variation in relation to the temperature variation in the vicinity of the heating temperature during pressurization with nip rolls. Accordingly, irrespective of the thickness or the like of the sheet, the step of pressurizing the laminate by using nip rolls can sufficiently perform the removal of air bubbles in the laminate, and thus, a sheet for forming a laminate, capable of producing a satisfactory laminate can be produced.
The preferable aspects of the sheet for forming a laminate of the present invention are as follows.
(1) The content of vinyl acetate in the ethylene-vinyl acetate copolymer is 30 to 50% by mass in relation to the ethylene-vinyl acetate copolymer. The above-described range is preferable because when the content of vinyl acetate is too high, the fluidity of the EVA in the vicinity of the heating temperature during pressurization with nip rolls sometimes becomes too high.
(2) The melt flow rate according to JIS-K7210 of the ethylene-vinyl acetate copolymer is larger than 0 g/10 min and 5 g/10 min or less. The above-described range is preferable because when the MFR is too small, the fluidity of the EVA in the vicinity of the heating temperature during pressurization with nip rolls sometimes becomes too low.
(3) The sheet for forming a laminate according to any one of claims 1 to 3, wherein the viscosity range of the ethylene-vinyl acetate copolymer at 60°C to 110°C is $1.0 \times 10^4$ to $3.0 \times 10^5$ Pa·s, and the viscosity variation rate (r) of the ethylene-vinyl acetate copolymer for the temperature change from 60°C to 90°C, as calculated by the following formula (I) is 90% or less:

$$r = (\eta_{60°C} - \eta_{90°C})/\eta_{60°C} \times 100(\%) \qquad (I)$$

where r represents the viscosity variation rate, $\eta_{60°C}$ and $\eta_{90°C}$ represent the viscosity at 60°C and the viscosity at 90°C of the ethylene-vinyl acetate copolymer, respectively.

When the ethylene-vinyl acetate copolymer has such physical properties, it is possible to make sufficiently low the probability of the incorporation of air bubbles in the step of pressurizing the laminate by using nip rolls.

(4) In (3), the viscosity variation rate (r) is 80% or less. The probability of the incorporation of air bubbles can be made further lower.

(5) The sheet is an intermediate film for a laminated glass or a sealing film for a solar cell. The degradation of the transparency due to air bubbles hardly occurs, and hence the sheet for forming a laminate of the present invention is most suitable for these applications.

The above-described object is achieved by a method for producing a laminate, comprising:

a step of obtaining a laminate by holding the sheet for forming a laminate according to any one of claims 1 to 6 between two or more sheets of another laminate material;
a pressure bonding step of bonding the laminate by application of pressure to the laminate with nip rolls after heating the laminate; and
a step of integrating the laminate by cross-linking by further heating the laminate after the pressure bonding step.

The method for producing a laminate of the present invention uses the sheet for forming a laminate of the present invention, and hence, even in the case of an EVA sheet, can sufficiently perform the removal of air bubbles in the laminate by the pressure bonding step of pressurizing the laminate by using nip rolls, and can produce a satisfactory laminate.

The preferable aspects of the method for producing a laminate of the present invention are as follows.

(1) The pressure bonding step is a step of allowing the laminate to pass through a heating furnace while being conveyed, and then applying pressure to the laminate by allowing the laminate to pass through between a pair of nip rolls.
(2) In the pressure bonding step, the laminate is heated such that the temperature of the sheet for forming a laminate is 55 to 95°C, before the application of pressure with nip rolls.
(3) The laminate is a laminated glass or a solar cell module.

Advantageous Effects of Invention

The sheet for forming a laminate of the present invention is suppressed, even in the case of an EVA sheet, in the viscosity variation in relation to the temperature variation in the vicinity of the heating temperature during pressurization, and hence, allows the removal of air bubbles in the laminate to be sufficiently performed by the step of application of pressure by using nip rolls. Accordingly, the method for producing a laminate of the present invention allows the laminate using an EVA sheet as a sheet for forming a laminate to be produced efficiently by using a continuous preliminary pressure bonding step, and with a satisfactory yield by suppressing, for example, the occurrence of exterior appearance failure due to the degradation of transparency.

Brief Description of Drawings

[Fig. 1] Fig. 1 is a schematic cross-sectional view illustrating a representative example of a method for producing a laminate according to the present invention.
[Fig. 2] Fig. 2 is a schematic cross-sectional view of a sheet of a general laminated glass.
[Fig. 3] Fig. 3 is a schematic cross-sectional view of a general solar cell module, (a) represents a solar cell module using a silicon crystal-based solar cell, (b) represents a solar cell module in which a thin-film solar cell element is formed on a front-side transparent protective member, and (c) represents a solar cell module in which a thin-film solar cell element is formed on a back-side protective member.
[Fig. 4] Fig. 4 is a graph illustrating the preferable viscosity-temperature property of the ethylene-vinyl acetate copolymer constituting the sheet for forming a laminate of an embodiment of the present invention.

Embodiment of Invention

The sheet for forming a laminate of the present invention is a sheet for forming a laminate to be used in a method for producing a laminate, including a step of application of pressure by using nip rolls. The sheet for forming a laminate of the present invention is formed of a composition (EVA composition) comprising at least EVA and a cross-linking agent, the content of vinyl acetate in the EVA is 30% by mass or more in relation to the EVA, and the melt flow rate according to JIS-K7210 of the EVA is 5 g/10 min or less. The MFR is a value measured under the conditions of 190°C and a load of 21.18 N.

Such an EVA composition can suppress the viscosity variation in relation to the temperature variation in the vicinity of the heating temperature during pressurization with nip rolls. Accordingly, even when the laminate is not uniformly heated before the application of pressure with nip rolls and the temperature distribution occurs in the plan view center and the plan view periphery or the like, there hardly occurs a large difference between the viscosities (fluidities) of the EVA in the plan view center and the plan view periphery or the like of the EVA sheet. Accordingly, the step of application of pressure by using nip rolls allows the removal of air bubbles in the laminate to be performed sufficiently, and thus a sheet for forming a laminate capable of producing a satisfactory laminate can be produced.

In the present invention, the content of vinyl acetate in EVA is preferably 30 to 50% by mass, furthermore preferably 30 to 45% by mass and particularly preferably 30 to 40% by mass in relation to EVA. When the content of vinyl acetate in EVA is too high, the fluidity of EVA in the vicinity of the heating temperature during pressurization with nip rolls is sometimes too high, or the impact resistance or the penetration resistance of the obtained laminate is sometimes degraded.

On the other hand, the MFR of EVA is preferably larger than 0 g/10 min and further preferably 0.1 g/10 min or more. When the MFR of EVA is too small, the fluidity of EVA in the vicinity of the heating temperature during pressurization with nip rolls is low, and thus, the laminate is sometimes required to be heated to a higher temperature. The MFR of EVA is preferably less than 4 g/10 min, further preferably 3 g/10 min or less, and particularly preferably 2 g/10 min or less. Thus, the viscosity variation in relation to the temperature variation can be more suppressed in the vicinity of the heating temperature during pressurization with nip rolls.

In the present invention, it is preferred that the viscosity range of EVA at 60°C to 110°C be $1.0 \times 10^4$ to $3.0 \times 10^5$ Pa·s, and the viscosity variation rate (r) of the ethylene-vinyl acetate copolymer for the temperature change from 60°C to 90°C, as calculated by the following formula (I) be 90% or less:

$$r = (\eta_{60°C} - \eta_{90°C})/\eta_{60°C}) \times 100(\%) \qquad (I)$$

where r represents the viscosity variation rate, $\eta_{60°C}$ and $\eta_{90°C}$ represent the viscosity at 60°C and the viscosity at 90°C of EVA, respectively. EVA having such a narrow viscosity range as described above in a relatively wide temperature range of from 60 to 110°C, hardly causes unevenness in the fluidity of the resin, and hardly incorporates air bubbles. EVA having the above-described viscosity variation rate (r) allows the unevenness of the fluidity to be further hardly caused in the pressurizing step with nip rolls allowing the resin surface temperature to be 60°C to 90°C, and allows the probability of the incorporation of air bubbles to be sufficiently low. When the melting point exceeds 60°C, the viscosity variation rate (r) is calculated by using the formula (I') :

$$r = (\eta(\text{melting point}) - \eta_{90°C})/\eta(\text{melting point})) \times$$

$$100(\%) \ (I')$$

where, $\eta$(melting point) represents the viscosity of EVA at the melting point, and the rest is the same as in formula (I).

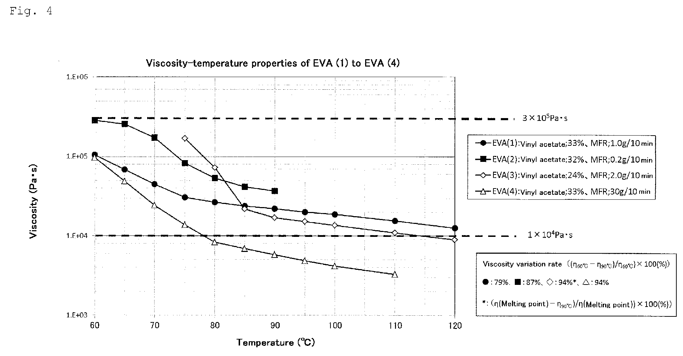

Moreover, the above-described viscosity variation rate (r) is preferably 80% or less. Fig. 4 shows the viscosity-temperature property of EVA. As shown in Fig. 4, in the EVA(1) in which the content of vinyl acetate is 33% by mass in relation to EVA and the MFR is 1.0 g/10 min, and the EVA(2) in which the content of vinyl acetate is 32% by mass in relation to EVA and the MFR is 0.2 g/10 min, the viscosity ranges at 60 to 110°C fall within the above-described range, and the viscosity variation rates (r) are 79% and 87%, respectively, to satisfy the above-described specification. On the other hand, in the EVA(3) in which the content of vinyl acetate is 24% by mass in relation to EVA and the MFR is 2.0 g/10 min, the viscosity range at 60 to 110°C falls outside the above described range and the viscosity variation rate (r) (as calculated with the formula (I') because the melting point exceeds 60°C) is 90%, and in the EVA(4) in which the content of vinyl acetate is 33% by mass in relation to EVA and the MFR is 30 g/10 min, the viscosity range at 60 to 110°C falls outside the above-described range and the viscosity variation rate (r) is also 94%.

The viscosities in Fig. 4 are the viscosities of EVA(1) to EVA(4) measured by using the viscometer Capilograph ID (furnace diameter: $\phi$9.55 mm, capillary: $\phi$1.0 $\times$ 10 mm, manufactured by Toyo Seiki Seisaku-sho, Ltd.) under the condition of a test speed of 1 mm/min, at different temperatures.

The sheet for forming a laminate of the present invention allows the air bubbles in the laminate to be sufficiently removed in the pressure bonding step of pressurizing the laminate by using nip rolls, hardly undergoes the occurrence of the degradation of the transparency of the laminate due to the air bubbles in the laminate, and hence can be most suitably used as an intermediate film for a laminated glass for which high transparency is critical, or a sealing film for a solar cell. These applications are described below.

[Cross-Linking Agent]

In the sheet for forming a laminate of the present invention, the cross-linking agent used in the EVA composition can form the cross-linked structure of EVA, and can improve the adhesiveness, strength and durability of the sheet for forming a laminate.

As a cross-linking agent, an organic peroxide is preferably used. As the organic peroxide, there can be used any organic peroxide that is decomposed at a temperature of 100°C or higher to generate radicals. In general, the organic peroxide is selected in consideration of the film formation temperature, the preparation conditions of the composition, the curing temperature, the heat resistance of the adherend, and the storage stability. In particular, an organic peroxide is preferable in which the 10 hour half-life decomposition temperature is 70°C or higher.

From the viewpoint of the processing temperature and the storage stability of the resin, examples of the organic peroxide include: benzoyl peroxide-based curing agents (such as benzoyl peroxide, 2,5-dimethylhexyl-2,5-bisperoxybenzoate, p-chlorobenzoyl peroxide, m-toluoyl peroxide, 2,4-dichlorobenzoyl peroxide, and t-butyl peroxybenzoate), tert-hexyl peroxypivalate, tert-butyl peroxypivalate, 3,5,5-trimethylhexanoyl peroxide, di-n-octanoyl peroxide, lauroyl peroxide, stearoyl peroxide, 1,1,3,3-tetramethylbutyl peroxy-2-ethylhexanoate, succinic acid peroxide, 2,5-dimethyl-2,5-di(tert-butylperoxy)hexane, 2,5-dimethyl-2,5-di(2-ethylhexanoylperoxy)hexane, 1-cyclohexyl-1-methylethylperoxy-2-ethyl hexanoate, tert-hexylperoxy-2-ethyl hexanoate, 4-methylbenzoyl peroxide, tert-butylperoxy-2-ethyl hexanoate, m-toluoyl benzoyl peroxide, benzoyl peroxide, 1,1-bis(tert-butylperoxy)-2-methylcyclohexane, 1,1-bis(tert-hexylperoxy)-3,3,5-trimethylcyclohexane, 1,1-bis(tert-hexylperoxy)cyclohexane, 1,1-bis(tert-butylperoxy)-3,3,5-trimethylcyclohexane, 1,1-bis(tert-butylperoxy)cyclohexane, 2,2-bis(4,4-di-tert-butylperoxycyclohexyl)propane, 1,1-bis(tert-butylperoxy)cyclododecane, tert-hexylperoxyisopropyl monocarbonate, tert-butylperoxymaleic acid, tert-butylperoxy-3,3,5-trimethylhexane, tert-butylperoxy laurate, 2,5-dimethyl-2,5-di(methylbenzoylperoxy)hexane, tert-butylperoxyisopropyl monocarbonate, tert-butylperoxy-2-ethylhexyl monocarbonate, tert-hexyl peroxybenzoate, and 2,5-dimethyl-2,5-di(benzoylperoxy)hexane. These cross-linking agents may be used each alone or in combinations of two or more thereof.

As organic peroxides, in particular, 2,5-dimethyl-2,5-di(tert-butylperoxy)hexane, 1,1-bis(tert-hexylperoxy)-3,3,5-trimethylcyclohexane, and tert-butylperoxy-2-ethylhexyl monocarbonate are preferable. With these organic peroxides, a sheet for forming a laminate, having excellent electric insulation is obtained. Such a sheet is effective when used as a sealing film for a solar cell.

The content of the organic peroxide is not particularly limited; however, the content of the organic peroxide is preferably 0.1 to 5 parts by mass, and more preferably 0.2 to 3 parts by mass, in relation to 100 parts by mass of EVA.

[Cross-Linking Aid]

In the sheet for forming a laminate of the present invention, the EVA composition may further include, if necessary, a cross-linking aid. The cross-linking aid improves the gel fraction rate of EVA, and can improve the adhesiveness and the durability of the EVA film.

The content of the cross-linking aid used is generally 10 parts by mass or less, preferably 0.1 to 5 parts by mass, and further preferably 0.1 to 2.5 parts by mass, in relation to 100 parts by mass of EVA. Accordingly, there is obtained a sheet for forming a laminate, further excellent in adhesiveness.

Examples of the cross-linking aid (a compound having a radical-polymerizable group as a functional group) may include, in addition to the trifunctional cross-linking aids such as triallyl cyanurate and triallyl isocyanurate, monofunctional or bifunctional cross-linking aids such as (meth)acrylic esters (for example, NK esters). Among these, triallyl cyanurate and triallyl isocyanurate are preferable, and triallyl isocyanurate is particularly preferable.

[Adhesion Improver]

In the sheet for forming a laminate of the present invention, the EVA composition may further include an adhesion improver in order to impart a further excellent adhesion force. As the adhesion improver, a silane coupling agent can be used. Examples of the silane coupling agent may include: γ-chloropropyltrimethoxysilane, vinyltriethoxysilane, vinyl-tris(β-methoxyethoxy)silane, γ-methacryloxypropyltrimethoxysilane, vinyltriacetoxysilane, γ-glycidoxypropyltrimethoxysilane, γ-glycidoxypropyltriethoxysilane, β-(3,4-epoxycyclohexyl)ethyl trimethoxysilane, vinyltrichlorosilane, γ-mercaptopropyltrimethoxysilane, γ-aminopropyltriethoxysilane, and N-β-(aminoethyl)-γ-aminopropyltrimethoxysilane. These silane coupling agents may be used each alone or in combinations of two or more thereof. Among these, γ-methacryloxypropyltrimethoxysilane is particularly preferable.

The content of the silane coupling agent is preferably 0.1 to 2 parts by mass, further preferably 0.1 to 0.65 parts by mass, and particularly preferably 0.1 to 0.4 parts by mass, in relation to 100 parts by mass of EVA.

[Others]

In the sheet for forming a laminate of the present invention, the EVA composition may comprise other additives, according to the applications of the sheet for forming a laminate. For example, when the sheet for forming a laminate of the present invention is used as an intermediate film for laminated glass or a sealing film for a solar cell, one or two or more of various additives such as a plasticizer, an acryloxy group-containing compound, a methacryloxy group-containing compound, an epoxy group-containing compound, an ultraviolet absorber, a light stabilizer, and an anti-aging agent may be added to the EVA composition, if necessary, in order to improve or regulate various physical properties (such as mechanical strength, adhesiveness, optical properties such as transparency, heat resistance, light resistance, and cross-linking rate). The addition amount of each of the various additives is preferably within a range of 5 parts by mass or less in relation to 100 parts by mass of EVA.

[Production of Sheet for Forming Laminate]

The method for producing the sheet for forming a laminate according to the present invention is not particularly limited and can be produced by forming the above-described EVA composition into a sheet shape by using a heretofore known method. For example, the sheet for forming a laminate according to the present invention can be produced by a method in which the EVA composition is mixed by heating and kneading EVA and a cross-linking agent, and if necessary, the above-described various materials in a super mixer (high speed fluidizing mixer), a twin-screw kneader, a roll mill or the like, and then the mixed EVA composition is molded into a sheet shape by extrusion molding or calender molding (calendering) or the like. After shaping into a sheet shape, a concave-convex shape pattern may be imparted to the surface of the sheet by pressing an emboss roller or an emboss plate against the surface of the sheet. The heating-kneading temperature and the molding temperature are preferably set at the temperatures at which the cross-linking agent does not react or little reacts. For example, the heating-kneading temperature and the molding temperature are 40 to 90°C, in particular, preferably 50 to 80°C.

In the case of using the EVA sheet in the production of a laminate including the pressure bonding step with nip rolls, the thickness of the EVA sheet has hitherto been restricted; however, in the case of the sheet for forming a laminate of the present invention, the viscosity variation in relation to the temperature variation is suppressed, and hence the thickness of the sheet for forming a laminate is not particularly limited, and can be appropriately set depending on the application. The thickness of the sheet for forming a laminate is generally in a range from 50 $\mu$m to 2 mm.

The sheet for forming a laminate of the present invention may be constituted with an EVA sheet, or may have a multi-layer structure formed by laminating two or more EVA sheets.

[Method for Producing Laminate]

The method for producing a laminate by using the sheet for forming a laminate of the present invention is described with reference to the accompanying drawings. The method for producing a laminate of the present invention produces a laminate by a step of obtaining a laminate (uncured) by holding the sheet for forming a laminate between two or more sheets of other laminate materials, a step of preliminary pressure bonding the laminate (uncured) by heating the laminate (uncured) and applying pressure to the laminate by using nip rolls, and a step of integration of the laminate by cross-linking by further heating the laminate subsequently (after preliminary pressure bonding). The method for producing a laminate of the present invention uses the sheet for forming a laminate of the present invention, and hence, as described above, even the EVA sheet is suppressed in the viscosity variation in relation to the temperature variation in the vicinity of the heating temperature during pressurization with nip rolls. Accordingly, the pressure bonding step with nip rolls allows the air bubbles in the laminate to be sufficiently removed, and thus, the subsequent heat cross-linking step allows a satisfactory laminate to be produced.

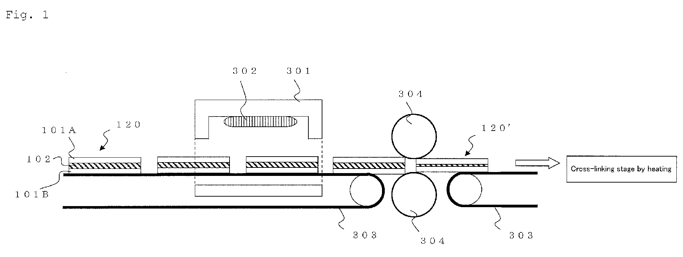

Fig. 1 is a schematic cross-sectional view illustrating a representative example of the method for producing a laminate of the present invention. In Fig. 1, first, a sheet for forming a laminate 102 is held between two substrates 101A and 101B to form a laminate (uncured) 120. While the laminate is being conveyed with a conveying apparatus 303, the laminate is allowed to pass through a heating furnace 301. The heating furnace 301 is equipped with a heater section 302, and can heat the sheet for forming a laminate 102 until the sheet for forming a laminate 102 reaches the predetermined temperature while the laminate (uncured) 120 is passing through the heating furnace 301. Subsequently, the laminate (uncured) 120 is allowed to pass between nip rolls 304 constituted with a pair of two rolls facing each other. The nip rolls 304 are an apparatus continuously pressurizing an object passing between the rolls with a predetermined linear load. Thus, the laminate (uncured) 120 is pressurized, and the heated sheet for forming a laminate 102 is bonded to the boundary surfaces of the substrates 101A and 101B by the application of pressure to the laminate, and thus a laminate (after preliminary pressure bonding) 120' is obtained. In this case, because the sheet for forming a laminate 102 is formed of the EVA having such a content of vinyl acetate and such an MFR as described above, even when the plan view center and the plan view periphery of the laminate (uncured) 120 are not uniformly heated by the heating furnace 301 and the temperature distribution occurs in the plan view center and the plan view periphery of the sheet for forming a laminate 102, the fluidity difference between the center and periphery is small, and thus the removal of the air bubbles from the boundary surfaces between the sheet for forming a laminate 102 and the substrates 101A and 101B by the step of pressurizing by using the nip rolls 304 is facilitated.

For the conveying apparatus 303, the heating furnace 301, and the nip rolls 304, heretofore known, corresponding apparatus, furnace and nip rolls can be used. The heating type of the heater section 32 of the heating furnace 301 can be any type, and examples of the heating type concerned include hot air heating type and infrared ray heating type. Instead of the heating furnace 301, a heating apparatus of heat roll type may also be used. The heating is not particularly limited as long as the temperature provided by the heating is the temperature causing no reaction of the cross-linking agent included in the EVA composition of the sheet for forming a laminate 102. In consideration of the fluidity, the stress relaxation during pressurization and the like of the sheet for forming a laminate 102, the laminate is heated before the pressurization with the nip rolls in such a way that the temperature of the sheet for forming a laminate 102 falls preferably within a range from 55 to 95°C, furthermore preferably within a range from 65 to 95°C, and particularly preferably within a range from 70 to 95°C. The temperature difference between the plan view center and the plan view periphery of the sheet for forming a laminate is preferably 15°C or less.

The nip rolls 304 can be of any types, and may have a plurality of pairs of nip rolls. The nip rolls may also be constituted with heat rolls in order to avoid the temperature decrease during pressurization. The linear load exerted by the nip rolls 304 is not particularly limited; however, the linear load is preferably 5 to 100 kN/m and furthermore preferably 10 to 50 kN/m.

A laminate can be obtained by performing, after the above-described pressure bonding step, a cross-linking integration step (heat cross-linking step) of heating the laminate (after preliminary pressure bonding) 120'. The heat cross-linking step can use a heretofore known method. For example, a high temperature-high pressure treatment such as a treatment using an autoclave or the like can be used. The heating conditions are not particularly limited, and also regulated by the mixing proportion of the cross-linking agent or the like included in the above-described EVA composition. Usually, the heating is performed at 100 to 155°C (in particular, in the vicinity of 130°C) for 10 minutes to 1 hour. The heating is preferably performed while pressurizing at a pressure of $1.0 \times 10^3$ Pa to $5.0 \times 10^7$ Pa. In this case, the cooling of the laminate after cross-linking is generally performed at room temperature, and in particular, the more rapid the cooling is, the more preferable. Air bubbles have been sufficiently removed from inside the laminate (after preliminary pressure bonding) 120' by the pressure bonding step of pressurizing by using nip rolls, and accordingly, a satisfactory laminate can be obtained by the heat cross-linking step.

According to the method for producing a laminate of the present invention, the removal of the air bubbles in the laminate can be sufficiently performed in the pressure bonding step of pressurizing by using nip rolls, the degradation of the transparency of the laminate due to air bubbles hardly occurs, and hence the method for producing a laminate of the present invention is suitable for the production of a laminated glass or a solar cell module required to have high transparency as a laminate.

[Production of Laminated Glass]

When a laminated glass is produced by the method for producing a laminate of the present invention, for example, the sheet for forming a laminate of the present invention is used, as the intermediate film 22 for a laminated glass, of the laminated glass shown in Fig. 2, and the transparent substrates 21A and 21B can be produced as other laminate materials according to the method for producing a laminate shown in Fig. 1. Specifically, the sheet for forming a laminate (intermediate film) is held between the two sheets of the transparent substrates such as two sheets of glass plates to form a laminate (uncured), the laminate is heated, then the laminate is preliminarily bonded by the application of pressure to the laminate with nip rolls and further heated to be integrated by cross-linking, and thus the laminated glass is produced.

As the transparent substrates, in addition to glass plates such as green glass, silicate glass, inorganic glass plate, and uncolored transparent glass plate, for example, substrates or films made of plastics such as polyethylene terephthalate (PET), polyethylene naphthalate (PEN), polyethylene butyrate, polymethyl methacrylate (PMMA) may also be used. Glass plates are preferable from the viewpoint of heat resistance, weatherability, impact resistance and the like. The thickness of the transparent substrate is generally approximately 0.1 to 20 mm. As the two sheets of transparent substrates, the same type of substrates may be used, or alternatively, a combination of different types of substrates may also be used.

[Production of Solar Cell Module]

When a solar cell module is produced, for example, the solar cell module can be produced according to the method for producing a laminate shown in Fig. 1, by using the sheet for forming a laminate of the present invention as the sealing films for a solar cell (front-side sealing film 33A and/or back-side sealing film 33B) in the solar cell modules shown in Figs. 3(a) to 3(c), and by using the front-side transparent protective member 31, the solar cell elements 34, and the back-side protective member 32, as other laminate materials. Specifically, in the case of the solar cell module of Fig. 3(a), the front-side transparent protective member, the sheet for forming a laminate (sealing film), the solar cell elements (cells for solar cell), the sheet for forming a laminate (sealing film), and the back-side protective member are laminated in this order; in the case of the solar cell module of Fig. 3(b), the sheet for forming a laminate (sealing film) is held between the front-side transparent protective member on the surface of which a thin film solar cell element is formed and the back-side protective member; and in the case of the solar cell module of Fig. 3(c), the sheet for forming a laminate (sealing film) is held between the front-side transparent protective member and the back-side protective member on the surface of which the thin film solar cell element is formed; thus, in each of these cases, a laminate (uncured) is formed, the laminate is heated, then the heated laminate is pressurized by using nip rolls to be subjected to preliminary pressure bonding, then the laminate is heated to be subjected to cross-linking integration, and thus a solar cell module is produced.

Examples of the solar cell element include: a single crystalline or polycrystalline silicon crystal-based cell for a solar cell in the case of the cell for the solar cell module of Fig. 3(a); and thin film silicon-based solar cell, thin film amorphous silicon-based solar cell, and copper indium selenide (CIS)-based solar cell element in the cases of the thin film solar cell elements of Figs. 3(b) and 3(c).

Examples of the front-side transparent protective member include a glass substrate such as a silicate glass substrate, a polyimide substrate, and a fluororesin-based transparent substrate. In particular, a glass substrate is preferable, and the glass substrate may be a chemically or thermally reinforced substrate. The thickness of the transparent substrate is generally 0.1 to 10 mm, and preferably 0.3 to 5 mm. As the back-side protective member, a film of a plastic such as polyethylene terephthalate (PET) is preferably used. In consideration of heat resistance and moist heat resistance, polyethylene fluoride film, in particular, a film obtained by laminating polyethylene fluoride film/Al/polyethylene fluoride film in this order may also be used.

Examples

Hereinafter, the present invention is described by way of Examples.

[Examples 1 and 2 and Comparative Examples 1 and 2]

1. Preparation of sheets for forming a laminate

The compositions having the formulations listed in Table 1 and Table 2 were kneaded with a roll mill at 60 to 70°C, and were shaped by calendering at 70°C to prepare sheets for forming a laminate (thickness; 0.5 mm).

2. Preparation of laminates (sheets of laminated glass)

Laminates (uncured) were formed in each of which the sheet for forming a laminate was held as an intermediate film between two sheets of glass plates (size: 1000 mm $\times$ 1000 mm, thickness: 3 mm), each of the resulting laminates was heated in such a way that the temperature of the sheet for forming a laminate listed in Table 1 or Table 2 was obtained, by using the heating apparatus (hot air heating type) and the pressure bonding apparatus having the pressurizing apparatus with nip rolls (see Fig. 1). Then each of the heated laminates was subjected to the preliminary pressure bonding and then subjected to a pressurizing treatment under the condition of a temperature of 135°C for 60 minutes with an autoclave, and thus, sheets of laminated glass were prepared. The temperature of each of the sheets for forming a laminate was measured as follows: a temperature indicator seal was attached to each of the plan view center and the plan view periphery of the sheet for forming a laminate, before the formation of the laminate, and the indicated temperature of the temperature indicator seal was measured.

The exterior appearance of each of the obtained sheets of laminated glass was observed and the state of the air bubbles was evaluated. In the evaluation of each of the prepared sheets of laminated glass, the case where no air bubbles capable of being visually identified were found on the surface of the prepared sheet of laminated glass was marked with O, and the case where air bubbles capable of being visually identified were found on the surface of the prepared sheet of laminated glass was marked with ×.

3. Evaluation Results

The evaluation results are shown in Table 1 and Table 2.

[Table 1]

| | | | Example 1 | | | | | | Example 2 | | | | | |
|---|---|---|---|---|---|---|---|---|---|---|---|---|---|---|
| Composition | EVA(1)[*1] | | 100 | 100 | 100 | 100 | 100 | 100 | - | - | - | - | - | - |
| | EVA(2)[*2] | | - | - | - | - | - | - | 100 | 100 | 100 | 100 | 100 | 100 |
| | EVA(3)[*3] | | - | - | - | - | - | - | - | - | - | - | - | - |
| | EVA(4)[*4] | | - | - | - | - | - | - | - | - | - | - | - | - |
| | Cross-linking agent[*5] | | 2 | 2 | 2 | 2 | 2 | 2 | 2 | 2 | 2 | 2 | 2 | 2 |
| | Cross-linking aid[*6] | | 1 | 1 | 1 | 1 | 1 | 1 | 1 | 1 | 1 | 1 | 1 | 1 |
| | Silane coupling agent[*7] | | 2 | 2 | 2 | 2 | 2 | 2 | 2 | 2 | 2 | 2 | 2 | 2 |
| | Ultraviolet absorber[*8] | | 0.05 | 0.05 | 0.05 | 0.05 | 0.05 | 0.05 | 0.05 | 0.05 | 0.05 | 0.05 | 0.05 | 0.05 |
| Step | Temperature of sheet for forming laminate before nip rolls (°C) | Center | 55 | 65 | 70 | 80 | 80 | 85 | 55 | 65 | 70 | 80 | 80 | 85 |
| | | Periphery | 60 | 70 | 75 | 90 | 95 | 95 | 60 | 70 | 75 | 90 | 95 | 95 |
| Evaluation | Evaluation of exterior appearance of laminated glass (state of air bubbles) | | O | O | O | O | O | O | × | × | O | O | O | O |

(Remarks)

*1: EVA(1): Content of vinyl acetate in EVA; 33% by mass, MFR; 1.0 g/10 min

*2: EVA(2): Content of vinyl acetate in EVA; 32% by mass, MFR; 0.2 g/10 min

*3: EVA(3): Content of vinyl acetate in EVA; 24% by mass, MFR; 2.0 g/10 min

*4: EVA(4): Content of vinyl acetate in EVA; 33% by mass, MFR; 30.0 g/10 min

*5: Cross-linking agent (2,5-dimethyl-2,5-bis(tert-butylperoxy)hexane)

*6: Cross-linking aid (triallyl isocyanurate)

*7: Silane coupling agent (KBM503; manufactured by Shin-Etsu Chemical Co., Ltd.)

*8: Ultraviolet absorber (Uvinul 3049; manufactured by BASF Japan Ltd.)

[Table 2]

| | | | Comparative Example 1 | | | | | | Comparative Example 2 | | | | | |
|---|---|---|---|---|---|---|---|---|---|---|---|---|---|---|
| Composition | EVA(1)[*1] | | - | - | - | - | - | - | - | - | - | - | - | - |
| | EVA(2)[*2] | | - | - | - | - | - | - | - | - | - | - | - | - |
| | EVA(3)[*3] | | 100 | 100 | 100 | 100 | 100 | 100 | - | - | - | - | - | - |
| | EVA(4)[*4] | | - | - | - | - | - | - | 100 | 100 | 100 | 100 | 100 | 100 |
| | Cross-linking agent[*5] | | 2 | 2 | 2 | 2 | 2 | 2 | 2 | 2 | 2 | 2 | 2 | 2 |
| | Cross-linking aid[*6] | | 1 | 1 | 1 | 1 | 1 | 1 | 1 | 1 | 1 | 1 | 1 | 1 |
| | Silane coupling agent[*7] | | 2 | 2 | 2 | 2 | 2 | 2 | 2 | 2 | 2 | 2 | 2 | 2 |
| | Ultraviolet absorber[*8] | | 0.05 | 0.05 | 0.05 | 0.05 | 0.05 | 0.05 | 0.05 | 0.05 | 0.05 | 0.05 | 0.05 | 0.05 |
| Step | Temperature of sheet for forming laminate before nip rolls (°C) | Center | 55 | 65 | 70 | 80 | 80 | 85 | 55 | 65 | 70 | 80 | 80 | 85 |
| | | Periphery | 60 | 70 | 75 | 90 | 95 | 95 | 60 | 70 | 75 | 90 | 95 | 95 |
| Evaluation | Evaluation of exterior appearance of laminated glass (state of air bubbles) | | × | × | × | × | × | O | O | O | × | × | × | × |

(Remarks)

*1 to 8: Same as for Table 1.

As shown in Table 1 and Table 2, in Examples 1 and 2 where the content of vinyl acetate in EVA was 30% by mass or more, the MFR was 5.0 g/10 min or less, the viscosity range of EVA at 60°C to 110°C was $1.0 \times 10^4$ to $3.0 \times 10^5$ Pa·s and the viscosity variation rate (r) of EVA for the temperature change from 60°C to 90°C was 90% or less as described above (see Fig. 4), it was shown that even when there was a temperature difference of 5 to 15°C between the plan view center and the plan view periphery of the sheet for forming a laminate, sheets of laminated glass satisfactory in exterior appearance were able to be prepared by the pressure bonding step of pressurizing with nip rolls in a range from 55 to 95°C (Example 1) or in a range from 70 to 95°C (Example 2). On the other hand, in Comparative Example 1 where the content of vinyl acetate in EVA was 24% by mass, the viscosity range at 60°C to 110°C was higher than the above-described range, and the viscosity variation rate (r) for the temperature change from the melting point to 90°C was 90%, and in Comparative Example 2 where the MFR was 30.0 g/10 min, the viscosity range at 60°C to 110°C was lower than the above-described range, and the viscosity variation rate (r) for the temperature change from 60°C to 90°C was 94%, sheets of laminated glass satisfactory in exterior appearance were able to be prepared only under certain temperature conditions, but were not able to be prepared under the other temperature conditions. In the case where the temperature difference is regulated so as to be smaller at high temperatures, the laminate is required to stay for a long time in the heating apparatus, and this is disadvantageous from the viewpoint of energy consumption and production time.

Industrial Applicability

According to the present invention, laminates such as sheets of laminated glass and solar cell modules can be provided by using a sheet for forming a laminate, including EVA inexpensive and excellent in adhesiveness and transparency.

Reference Signs List

101A, 101B Substrate
102 Sheet for forming a laminate
120 Laminate (uncured)
120' Laminate (after preliminary pressure bonding)
301 Heating furnace
302 Heater section
303 Conveying apparatus
304 Nip roll
21A, 21B Glass plate
22 Intermediate film for a laminated glass
31 Front-side transparent protective member
32 Back-side protective member
33A, 33B Sealing film for a solar cell
34 Solar cell element

**Claims**

1. A sheet for forming a laminate used in a method for producing a laminate comprising a step of application of pressure by using nip rolls, wherein
   the sheet for forming a laminate is formed of a composition comprising an ethylene-vinyl acetate copolymer and a cross-linking agent,
   the content of vinyl acetate in the ethylene-vinyl acetate copolymer is 30% by mass or more in relation to the ethylene-vinyl acetate copolymer, and
   the melt flow rate according to JIS-K7210 of the ethylene-vinyl acetate copolymer is 5 g/10 min or less.

2. The sheet for forming a laminate according to claim 1, wherein the content of vinyl acetate in
   the ethylene-vinyl acetate copolymer is 30 to 50% by mass in relation to the ethylene-vinyl acetate copolymer.

3. The sheet for forming a laminate according to claim 1 or 2, wherein the melt flow rate according to JIS-K7210 of the ethylene-vinyl acetate copolymer is larger than 0 g/10 min and 5 g/10 min or less.

4. The sheet for forming a laminate according to any one of claims 1 to 3, wherein the viscosity range of the ethylene-vinyl acetate copolymer at 60°C to 110°C is $1.0 \times 10^4$ to $3.0 \times 10^5$ Pa·s, and the viscosity variation rate (r) of the ethylene-vinyl acetate copolymer for the temperature change from 60°C to 90°C, as calculated by the following formula (I) is 90% or less:

$$r = (\eta_{60°C} - \eta_{90°C})/\eta_{60°C} \times 100 (\%) \qquad (I)$$

where r represents the viscosity variation rate, $\eta_{60°C}$ and $\eta_{90°C}$ represent the viscosity at 60°C and the viscosity at 90°C of the ethylene-vinyl acetate copolymer, respectively.

5. The sheet for forming a laminate according to claim 4, wherein the viscosity variation rate (r) is 80% or less.

6. The sheet for forming a laminate according to any one of claims 1 to 5, wherein the sheet is an intermediate film for a laminated glass or a sealing film for a solar cell.

7. A method for producing a laminate, comprising:

   a step of obtaining a laminate by holding the sheet for forming a laminate according to any one of claims 1 to 6 between two or more sheets of another laminate material;
   a pressure bonding step of bonding the laminate by application of pressure to the laminate with nip rolls after heating the laminate; and
   a step of integrating the laminate by cross-linking by further heating the laminate after the pressure bonding step.

8. The method for producing a laminate according to claim 7, wherein the pressure bonding step is a step of allowing the laminate to pass through a heating furnace while being conveyed, and then applying pressure to the laminate by allowing the laminate to pass through between a pair of nip rolls.

9. The method for producing a laminate according to claim 7 or 8, wherein, in the pressure bonding step, the laminate is heated such that the temperature of the sheet for forming a laminate is 55 to 95°C, before the application of pressure with nip rolls.

10. The method for producing a laminate according to any one of claims 7 to 9, wherein the laminate is a laminated glass or a solar cell module.

Fig. 1

Cross-linking stage by heating

Fig. 2

21A

22

21B

Fig. 3

(a)

31    34    34

33A

33B

34    32

(b)

31

34

33B

32

(c)

31

33A

34

32

Fig. 4

Viscosity–temperature properties of EVA (1) to EVA (4)

## INTERNATIONAL SEARCH REPORT

| | International application No. |
|---|---|
| | PCT/JP2014/067281 |

**A. CLASSIFICATION OF SUBJECT MATTER**
*C09J131/04*(2006.01)i, *B32B7/12*(2006.01)i, *C03C27/12*(2006.01)i, *C09J5/06*(2006.01)i, *C09J7/00*(2006.01)i, *C09J11/06*(2006.01)i, *C09J123/08*(2006.01)i

According to International Patent Classification (IPC) or to both national classification and IPC

**B. FIELDS SEARCHED**

Minimum documentation searched (classification system followed by classification symbols)
C09J131/04, B32B7/12, C03C27/12, C09J5/06, C09J7/00, C09J11/06, C09J123/08

Documentation searched other than minimum documentation to the extent that such documents are included in the fields searched
Jitsuyo Shinan Koho          1922–1996   Jitsuyo Shinan Toroku Koho   1996–2014
Kokai Jitsuyo Shinan Koho    1971–2014   Toroku Jitsuyo Shinan Koho   1994–2014

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2007/072944 A1  (Bridgestone Corp.), 28 June 2007 (28.06.2007), claims 1, 11; paragraphs [0009], [0041], [0049], [0050], [0057] & JP 5105419 B          & US 2010/0300531 A1 & EP 1965440 A1          & CN 101341598 A | 1-10 |
| Y | JP 2012-66984 A  (Bridgestone Corp.), 05 April 2012 (05.04.2012), claims 1 to 3, 8; paragraphs [0010], [0023] to [0027], [0056], [0060], [0061]; fig. 1, 2; tables 1, 2 & EP 2623470 A1          & WO 2012/043206 A1 & CN 103124702 A | 1-10 |

| ☒ Further documents are listed in the continuation of Box C. | | ☐ See patent family annex. |
|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 29 August, 2014 (29.08.14) | 09 September, 2014 (09.09.14) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.

PCT/JP2014/067281

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2010-144062 A (Dainippon Printing Co., Ltd.), 01 July 2010 (01.07.2010), claim 1; paragraphs [0007], [0011], [0018] to [0020] (Family: none) | 1-10 |
| A | JP 7-169986 A (Bridgestone Corp.), 04 July 1995 (04.07.1995), entire text; all drawings (Family: none) | 1-10 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11209150 A
- JP 7169986 A
- JP 2012066984 A